(19) Europäisches Patentamt
European Patent Office
Office européen des brevets

(11) **EP 2 830 107 B1**

(12) **EUROPÄISCHE PATENTSCHRIFT**

(45) Veröffentlichungstag und Bekanntmachung des Hinweises auf die Patenterteilung:
**21.12.2016 Patentblatt 2016/51**

(51) Int Cl.:
*H01L 39/14* *(2006.01)*       *H01L 39/16* *(2006.01)*
*H01L 39/24* *(2006.01)*

(21) Anmeldenummer: **14178335.7**

(22) Anmeldetag: **24.07.2014**

(54) **Bandförmiges, supraleitendes Element mit verbessertem Eigenschutz im Quenchfall**

Tape-shaped, superconducting element with improved self-protection fields in case of quenching

Élément supraconducteur en forme de bande présentant une autoprotection améliorée en cas de transition supraconductrice

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **24.07.2013 DE 102013214447**

(43) Veröffentlichungstag der Anmeldung:
**28.01.2015 Patentblatt 2015/05**

(73) Patentinhaber: **Bruker HTS GmbH**
**63450 Hanau (DE)**

(72) Erfinder: **Usoskin, Alexander**
**63456 Hanau (DE)**

(74) Vertreter: **Kohler Schmid Möbus Patentanwälte Partnerschaftsgesellschaft mbB**
**Ruppmannstraße 27**
**70565 Stuttgart (DE)**

(56) Entgegenhaltungen:
EP-A1- 2 192 629       JP-A- 2012 028 263
US-A- 5 132 283        US-A1- 2005 019 615
US-A1- 2009 131 262    US-A1- 2009 302 282
US-A1- 2010 197 506    US-A1- 2011 319 271

**Beschreibung**

Die Erfindung betrifft ein supraleitendes Element, umfassend ein metallisches Substrat, eine Isolationsschicht, eine Supraleiterschicht und eine metallische Schutzschicht, wobei die Isolationsschicht zwischen dem Substrat und der Supraleiterschicht angeordnet ist, wobei die Isolationsschicht in einem Querschnitt des supraleitenden Elements sich beidenends über den von der Supraleiterschicht überdeckten Bereich des Substrats hinaus erstreckt, und wobei die Isolationsschicht die Supraleiterschicht und die metallische Schutzschicht vom Substrat galvanisch trennt.

Ein solches supraleitendes Element ist aus der US 2009/0131262 A1 bekannt geworden.

Supraleitende Materialien können große elektrische Ströme ohne ohmsche Verluste tragen. Sie werden beispielsweise in Magnetspulen oder auch in resistiven und induktiven Fehlerstrombegrenzern eingesetzt.

Supraleitenden Eigenschaften stellen sich insbesondere nur bei vergleichsweise niedrigen Temperaturen ein, die eine Kühlung, typischerweise mit flüssigem Helium, erfordern. Hochtemperatursupraleiter (HTSL) wie YBCO weisen dabei höhere Sprungtemperaturen und Stromtragfähigkeiten als herkömmliche metallische Supraleiter wie NbTi oder Nb3Sn auf. HTSL sind jedoch wegen spröder Materialeigenschaften schwierig zu verarbeiten; sie werden daher meist in Bandform gefertigt, wobei eine dünne HTSL-Schicht auf einem flexiblen Substrat abgeschieden wird.

Eine grundsätzliche Gefahr bei der Verwendung von Supraleitern ist ein plötzlicher Übergang in den normalleitenden Zustand ("Quench"). Der bisher supraleitend im Supraleiter getragene Strom versucht sodann, durch das normalleitende Material weiter zu fließen. Dabei können sich erhebliche elektrische Spannungen am gequenchten Supraleiter aufbauen, und es kommt zu Wärmeentwicklung aufgrund ohmscher Verluste. Dabei kann der Supraleiter auch irreversibel beschädigt werden ("Burnout").

Im Allgemeinen ist es erwünscht, dass ein Supraleiter einen Quench ohne Beschädigungen übersteht. Hierfür ist es bekannt, Supraleiter durch parallele, normalleitende Strompfade mit niedrigem Widerstand ("Shunt") zu schützen. Der zuvor supraleitend getragene Strom kann dann im Quenchfall durch den parallelen Strompfad fließen, wodurch die elektrischen Spannungen und die Erwärmung vermindert werden. Als parallele, normalleitende Strompfade werden bei bandförmigen Supraleiterstrukturen insbesondere Shunt-Beschichtungen, etwa aus Kupfer, eingesetzt, und auch metallische Substrate werden genutzt, vgl. hierzu beispielsweise die US 7,774,035 B2. Weiterhin sind externe Shuntsysteme, die über Brückenelemente angekoppelt sind, bekannt, vgl. etwa die EP 2 117 056 B1.

Die nachveröffentlichte europäische Patentanmeldung EP 2 672 537 A1 schlägt vor, bei im Verhältnis zur Breite relativ kurzen bandförmigen Supraleitern den internen Shuntwiderstand relativ hoch zu wählen, um die Gefahr eines Burnouts zu verringern. Ein metallisches Substrat wird hierbei vom einem supraleitenden Film durch eine dazwischenliegende, elektrisch isolierende Zwischenschicht separiert. Eine dünne Schutzschicht aus Edelmetall ist auf dem supraleitenden Film angeordnet.

Aus der EP 2 192 629 A1 ist ein Fehlerstrombegrenzer mit einer Supraleiteranordnung bekannt geworden, bei der die supraleitenden Filme von supraleitenden Elementen elektrisch miteinander verbunden sind, die elektrisch leitfähigen Substrate der supraleitenden Elemente jedoch voneinander isoliert sind. Zwischen den supraleitenden Filmen und den leitfähigen Substraten der supraleitenden Elemente sind jeweils isolierende Zwischenschichten angeordnet.

Aus der US 2012/0040100 A1 ist es bekannt geworden, ein metallisches Substrat mittels Planarisierung durch Abscheidung aus der Lösung (Solution Deposition Planarization, SDP) einschließlich einer Tauchbeschichtung (Dip coating) und einer Wärmebehandlung mit einer Y2O3-Schicht zu versehen, anschließend eine MgO-Pufferschicht aufzubringen, und auf der Pufferschicht einen YBCO-Film abzuscheiden. Durch die SDP-Behandlung des Substrats kann dessen Rauhigkeit verringert und die Qualität des YBCO-Films verbessert werden.

Die DE 10 2004 048 439 B4 beschreibt einen Supraleiterdraht mit einer elektrischen Isolation aus einem Band, das helixartig um den Supraleiterdraht gewickelt ist. Insbesondere kann der Supraleiterdraht als HTS-Dünnschichtdraht mit einer YBCO-Beschichtung und das Band als Polyesterfolie mit 2 $\mu$m Dicke und 50% Überlapp ausgebildet sein.

Die US 2011/0319271 A1 beschreibt einen Multifilament-Supraleiter, wobei auf der Oberseite eines metallischen Substrats eine Pufferschicht und mehrere Streifen von Supraleiter im Wechsel mit isolierenden Streifen aufgebracht sind. Die Supraleiterstreifen sind mit einer Schutzschicht und einer Stabilisierungsschicht zur elektrischen Stabilisierung versehen.

Die JP 2012 028263 A beschreibt ein Verfahren zur Fertigung eines bandförmigen, oxidischen Supraleiters, wobei verschiedene linienförmige Supraleiterstreifen mit einer Photoresist-Technik auf einem Zwischenschichten tragenden Substrat aufgetragen werden.

Die US 2009/0131262 A1 beschreibt Multifilament-Hochtemperatur-Supraleiter, wobei auf der Oberseite eines Substrats eine Pufferschicht und mehrere HTS-Streifen angeordnet sind. Auf den HTS-Streifen ist eine Schutzschicht aus Edelmetall und eine Stabilisierungsschicht angeordnet, wobei die Schutzschicht und die Stabilisierungsschicht das Substrat auch seitlich und von unten umgreifen. In einer anderen Ausführungsform werden zwei HTS-Streifen von der Schutzschicht und der Stabilisierungsschicht haubenartig umgriffen. In einer weiteren Ausführungsform wird vorgeschlagen, Pufferschicht, HTS-Material und Schutzschicht auf beiden Seiten des Substrats aufzutragen.

Die US 2009/0302282 A1, die US 2005/0019615 A1 und die US 2010/0197506 A1 beschreiben jeweils Supraleiter, die per Tauchbeschichtung hergestellte isolierende Schichten aufweisen.

Aufgabe der Erfindung

Der Erfindung liegt die Aufgabe zugrunde, ein supraleitendes Element bereitzustellen, bei dem die Gefahr einer Beschädigung im Quenchfall verringert ist.

Kurze Beschreibung der Erfindung

Diese Aufgabe wird gelöst durch ein supraleitendes Element der eingangs genannten Art, das dadurch gekennzeichnet ist, dass eine Dicke D der Isolationsschicht so gewählt ist, dass das supraleitende Element eine transversale Durchbruchspannung vom metallischen Substrat zur Supraleiterschicht und zur metallischen Schutzschicht von wenigstens 25 V aufweist, und dass die Isolationsschicht im Querschnitt auch die kurzen Seiten des Substrats ganz abdeckt.
Das erfindungsgemäße supraleitende Element sieht vor, den Eigenschutz des supraleitenden Elements durch eine weitgehende Unterdrückung der Energieabgabe im Quenchfall zu verbessern. Durch die Isolation des elektrisch gut leitfähigen, metallischen Substrats von der Supraleiterschicht wird der Shuntwiderstand hoch gehalten. Durch den hohen ohmschen Widerstand im Bereich der Supraleiterschicht im Quenchfall wird wiederum der Stromfluss durch das supraleitende Element begrenzt und dadurch die Wärmeentwicklung am supraleitenden Element verringert. Das supraleitende Element kann dann nach einem Quench schneller wieder unter die Sprungtemperatur gekühlt werden, und entsprechend schneller wieder in den Normalbetrieb zurückgeführt werden; zudem ist die Gefahr einer beschädigenden Überhitzung verringert.
Gemäß der Erfindung wird eine metallische Schutzschicht auf der Supraleiterschicht eingesetzt. Die metallische Schutzschicht blockiert oder erschwert Diffusionsvorgänge an der Oberseite der Supraleiterschicht bzw. allgemein von der Oberseite der Supraleiterschicht ausgehende chemische Veränderungen in der Supraleiterschicht, und sichert so die physikalischen Eigenschaften der Supraleiterschicht und somit deren Funktion als Supraleiter. Die metallische Schutzschicht, die typischerweise aus einem Edelmetall oder einer Edelmetalllegierung besteht, stellt zwar einen normalleitenden Strompfad parallel zur Supraleiterschicht dar, jedoch ist dieser aufgrund der geringen Dicke der metallischen Schutzschicht (typischerweise 0,5 $\mu$m oder weniger) recht hochohmig, so dass eine zugehörige Wärmeentwicklung im Quenchfall gering bleibt bzw. durch geeignete Wahl der Schichtdicke der metallischen Schutzschicht gering gehalten werden kann.
Um eine unerwünschte oder gar für das supraleitende Element beschädigungsträchtige Wärmeentwicklung zu verhindern, sieht die Erfindung vor, mit der Isolationsschicht im Querschnitt (senkrecht zur Längsrichtung/Stromflussrichtung des supraleitenden Elements) zu beiden Seiten der Supraleiterschicht über diese hinaus zu ragen und auch die kurzen Seiten des Substrats ganz abzudecken. Eine metallische Schutzschicht, die die Supraleiterschicht vollständig bedeckt, insbesondere auch an deren im Querschnitt kurzen Seiten, kann dann leicht auf der Isolationsschicht (im Bereich von deren Überstand über die Supraleiterschicht) enden, ohne das metallische Substrat zu berühren. Dadurch, dass die Supraleiterschicht eine geringere Breite aufweist als die Isolationsschicht, kann auch eine versehentliche direkte Kontaktierung des metallischen Substrats durch die Supraleiterschicht sicher verhindert werden. Erfindungsgemäß ist vorgesehen, dass die Isolationsschicht im Querschnitt auch die kurzen Seiten des Substrats ganz abdeckt. Dadurch kann eine versehentliche direkte Kontaktierung des metallischen Substrats bei einer Abscheidung der Supraleiterschicht oder auch der metallischen Schutzschicht auf der Oberseite des Substrats noch besser verhindert werden, und ein Spannungsdurchbruch noch unwahrscheinlicher gemacht werden.
Gemäß der Erfindung wird eine Isolationsschicht mit einer hohen transversalen Durchbruchspannung eingesetzt. Ein transversaler Spannungsdurchbruch (senkrecht zur Längsrichtung des supraleitenden Elements), typischerweise senkrecht zur Grenzfläche der Isolationsschicht zum Substrat, würde das metallische Substrat direkt oder indirekt über die metallische Schutzschicht mit der Supraleiterschicht verbinden und so einen parallelen, normalleitenden Strompfad geringen Widerstands eröffnen, der eine merkliche Erwärmung des supraleitenden Elements im Quenchfall zur Folge hätte. Man beachte, dass die Supraleiterschicht und die metallische Schutzschicht im Wesentlichen auf dem gleichen elektrischen Potential liegen, und ein Spannungsdurchbruch dort stattfindet, wo (i) die Isolationsschicht wegen variabler Dicke am schwächsten ist ("weak spot") und/oder (ii) das elektrische Feld wegen z.B. Oberflächenrauigkeit maximiert ist, was je nach Geometrie des supraleitenden Elements sowohl zur Supraleiterschicht als auch zur metallischen Schutzschicht gegeben sein kann.
Durch eine hohe transversale Durchbruchspannung, die durch geeignete Materialwahl und geeignete Wahl der Dicke der Isolationsschicht eingestellt und nötigenfalls experimentell überprüft werden kann, kann ein solcher Durchbruch effektiv verhindert werden. Die Dicke der Isolationsschicht ist typischerweise im supraleitenden Element einheitlich. Es empfiehlt sich, die Anwendung des erfindungsgemäßen supraleitenden Elements so zu wählen, dass im Quenchfall über dem supraleitenden Element maximal eine Spannung abfällt, die unterhalb der Durchbruchspannung liegt.
Ein erfindungsgemäßes supraleitendes Element kann vielfältig eingesetzt werden, insbesondere in Stromleitungen, Magnetspulen und supraleitenden Fehlerstrombegrenzern. Sie können wiederholten oder auch lang andauernden Quenchs, etwa durch Überströme in einem Fehlerstrombegrenzer, beschädigungsfrei widerstehen.

Für die Supraleiterschicht kann insbesondere YBCO oder ein anderes Supraleitermaterial vom ReBCO-Typ verwendet werden (Re: Seltene-Erden-Element). Das Substrat ist meist aus Stahl oder Hastalloy. Das Substrat ist üblicherweise bandförmig ausgebildet, meist mit einer Breite zwischen 0,5 cm und 8 cm, bevorzugt zwischen 2,5 cm und 5 cm, und mit einer Dicke zwischen 0,05 mm und 0,5 mm, bevorzugt zwischen 0,1 mm und 0,2 mm.

Bevorzugte Ausführungsformen der Erfindung

Bei einer vorteilhaften Ausführungsform des erfindungsgemäßen supraleitenden Elements berührt die metallische Schutzschicht die Isolationsschicht. Die Isolationsschicht verhindert in diesem Fall auch unmittelbar einen Spannungsdurchbruch vom Substrat zur metallischen Schutzschicht. Das Abscheiden der metallischen Schutzschicht ist in diesem Fall vereinfacht, und die Supraleiterschicht kann auch an den Seiten gut durch die metallische Schicht versiegelt werden. Bevorzugt erstreckt sich in diesem Fall die Isolationsschicht auch beidenends über den von der Supraleiterschicht und der metallischen Schutzschicht überdeckten Bereich des metallischen Substrats hinaus, um eine versehentliche direkte Kontaktierung des metallischen Substrats leicht zu verhindern.

Bevorzugt ist auch eine Ausführungsform, bei der die metallische Schutzschicht im Querschnitt die Supraleiterschicht haubenartig umschließt. Dadurch ist eine gute allseitige Versiegelung der Supraleiterschicht, insbesondere an deren Seitenflächen, gegeben, so dass chemische Veränderungen an der Supraleiterschicht blockiert oder minimiert sind.

Vorteilhaft ist weiterhin eine Ausführungsform, bei der die Isolationsschicht auch eine der Supraleiterschicht abgewandte Unterseite des Substrats abdeckt. Die Unterseite ist aufgrund ihrer großen Fläche auch bei einer Verbindung zur Supraleiterschicht mit schlecht leitendem Material unter Umständen ein nicht zu vernachlässigender Kontaktbereich. Durch die Anbringung der Isolationsschicht auch an der Unterseite des Substrats können Strompfade, die durch die Unterseite des Substrats führen, effektiv blockiert werden. Ein Spannungsdurchbruch wird noch unwahrscheinlicher. Bei dieser Ausführungsform umhüllt die Isolationsschicht im Querschnitt das Substrat allseitig. Dadurch wird sehr zuverlässig eine Nutzung des metallischen Substrats als paralleler Strompfad im Quenchfall ausgeschlossen. Zudem ist in diesem Fall die Abscheidung der Isolationsschicht durch eine Precursor-Route bzw. Abscheidung aus der flüssigen Phase, mit Dip-coating und anschließendem Tempern, leicht möglich. Aufgrund der für die Erfindung erforderlichen Schichtdicken der Isolationsschicht kann dabei ein wiederholtes Beschichten vorgenommen werden.

Bevorzugt ist weiterhin eine Ausführungsform, bei der zusätzlich zur Isolationsschicht eine Planarisierungsschicht vorgesehen ist, die auf dem Substrat abgeschieden ist. Mit einer Planarisierungsschicht kann die Oberflächenrauhigkeit des metallischen Substrats reduziert werden, und so die Qualität der Supraleiterschicht verbessert werden. Alternativ kann auch die Isolationsschicht gleichzeitig als Planarisierungsschicht dienen. Die Planarisierungsschicht weist bevorzugt eine Dicke von 0,2 bis 5 $\mu$m auf, bevorzugt 0,5 bis 2 $\mu$m. Die Planarisierungsschicht ist bevorzugt aus Yttriumoxid oder Zirkoniumoxid, und kann das Substrat allseitig umhüllen.

Bei einer vorteilhaften Ausführungsform ist die Dicke D der Isolationsschicht so gewählt, dass das supraleitende Element eine transversale Durchbruchspannung vom metallischen Substrat zur Supraleiterschicht und zur metallischen Schutzschicht von wenigstens 50 V, bevorzugt wenigstens 100 V, besonders bevorzugt wenigstens 300 V, aufweist. Dadurch kann das supraleitende Element bei höheren externen Spannungen eingesetzt werden, ohne dass es im Quenchfall zu einer übermäßigen Erwärmung des supraleitenden Elements kommt. Die transversale Durchbruchspannung liegt im Allgemeinen zwischen 25 und 1500 V, und bevorzugt zwischen 50 und 500 V.

Vorteilhaft ist eine Ausführungsform, bei der die Isolationsschicht eine Dicke D von wenigstens 0,2 $\mu$m, bevorzugt von wenigstens 2,0 $\mu$m, besonders bevorzugt von wenigstens 3,5 $\mu$m, ganz besonders bevorzugt wenigstens 5,0 $\mu$m, aufweist. Im allgemeinen führen höhere Schichtdicken zu höheren Durchbruchspannungen. Geringe Schichtdicken, etwa von weniger al 1 $\mu$m, können in der Regel nur mit hochisolierenden Materialien erreicht werden, insbesondere mit Aluminiumphosphat oder Aluminiumoxid. Typischerweise beträgt die Dicke der Isolationsschicht maximal 10 $\mu$m, gelegentlich ist auch eine Schichtdicke von maximal 3 $\mu$m vorgesehen. Man beachte, dass die Isolationsschicht im Allgemeinen auch eine Schichtstruktur aufweisen kann; bevorzugt ist die Isolationsschicht aber einheitlich (homogen) ausgebildet.

Bei einer bevorzugten Ausführungsform enthält die Isolationsschicht ein oder mehrere Metalloxide, insbesondere yttriumstabilisiertes Zirkonoxid, Zirkonoxid, Yttriumoxid, Strontiumtitanat, Aluminiumoxid, Ceroxid, Gadoliniumzirkonat, Bariumzirkonat und/oder Magnesiumoxid. Metalloxide sind leicht abzuscheidende, gut elektrisch isolierende Materialien. Die Isolationsschicht kann einfache oder mehrfache Oxide insbesondere von Elementen der zweiten oder dritten Hauptgruppe des Periodensystems der Elemente oder Mischungen davon enthalten.

Ebenfalls bevorzugt ist eine Ausführungsform, bei der die Isolationsschicht Aluminiumphosphat enthält, insbesondere wobei die Isolationsschicht eine Mischung aus Aluminiumphosphat mit Siliziumoxid, Germaniumoxid, Zirkonoxid, Yttriumoxid, Strontiumtitanat, Aluminiumoxid, Ceroxid, Gadoliniumzirkonat, Bariumzirkonat und/oder Magnesiumoxid enthält. Aluminiumphosphat hat sich in der Praxis als besonders effizienter elektrischer Isolator erwiesen.

Bevorzugt ist weiterhin eine Ausführungsform, bei der das supraleitende Element eine Pufferschicht enthält, wobei die Pufferschicht zwischen der Isolationsschicht und der Supraleiterschicht angeordnet ist, insbesondere wobei die Pufferschicht wenigstens eine dielektrische Sub-Schicht enthält. Mit einer Pufferschicht kann - unabhängig von den Eigenschaften der Isolationsschicht - eine für die Abscheidung der Supraleiterschicht optimale Oberfläche bereitgestellt werden, und so eine besonders hohe Qualität der Supraleiterschicht (des Supraleiterfilms) erreicht werden. Man beachte, dass die Pufferschicht auch wenigstens eine metallische Sub-Schicht enthalten kann. Typische Materialien, die in der Pufferschicht verwendet werden können, sind $CeO_2$, MgO und InSn. Die Pufferschicht wird typischerweise mit IBAD (ion beam assisted deposition, Ionenstrahlunterstützte Abscheidung) abgeschieden. Alternativ zu dieser Ausführungsform kann auch die Isolationsschicht bzw. ein oberer Teil davon als Pufferschicht eingesetzt werden.

Vorteilhaft ist weiterhin eine Ausführungsform, bei der im Längsschnitt des supraleitenden Elements näherungsweise in der Mitte der Isolationsschicht eine elektrisch leitende Verbindung zwischen dem metallischen Substrat und der Supraleiterschicht eingerichtet ist. Dadurch kann die im Quenchfall über der Isolationsschicht anliegende Spannung bzw. elektrische Feldstärke $E_\perp$ näherungsweise halbiert werden.

Bevorzugt ist weiterhin eine Ausführungsform, die vorsieht, dass die metallische Schutzschicht eine Dicke zwischen 0,07 $\mu$m und 3 $\mu$m aufweist, und/oder dass die metallische Schutzschicht Ag, Au, Rt, Pd, Cu, Ni, Cr, Al, Y oder deren Mischungen oder Legierungen enthält. Diese Dicken und Materialien haben sich in der Praxis bewährt. Man beachte, dass die Dicke der metallischen Schutzschicht bevorzugt mit 0,5 $\mu$m oder weniger gewählt wird, um den internen Shuntwiderstand entsprechend gering zu halten, und auch um die Herstellungskosten vor allem bei der Verwendung von teuren Metallen wie Gold und Silber in der metallischen Schutzschicht gering zu halten.

Bevorzugt ist weiterhin eine Ausführungsform, bei der die metallische Schutzschicht einen longitudinalen Widerstand in Längsrichtung des supraleitenden Elements zwischen 5 und 100 Ohm pro m Länge und je cm Breite des supraleitenden Elements aufweist, bevorzugt zwischen 15 und 40 Ohm pro m Länge und je cm Breite des supraleitenden Elements. Mit diesen Widerstandswerten hat sich in der Praxis ein gutes Verhalten im Quenchfall, insbesondere mit einer nur geringen Erwärmung des supraleitenden Elements, ergeben.

In den Rahmen der vorliegenden Erfindung fällt auch die Verwendung eines erfindungsgemäßen, oben beschriebenen supraleitenden Elements an einer äußeren Spannungsquelle, durch die im Quenchfall des supraleitenden Elements eine äußere Spannung $V_{ext}^{elem}$ am supraleitenden Element anliegt, wobei die Länge L des supraleitenden Elements so gewählt ist, dass das sich im Quenchfall einstellende elektrische Feld $E_\parallel$ entlang des supraleitenden Elements, das sich mit $E_\parallel = V_{ext}^{elem}/L$ ergibt, kleiner ist als ein kritisches elektrisches Feld $E_\parallel^{krit}$, das die Supraleiterschicht noch ohne Beschädigungen aushalten kann,

und wobei die Dicke D der Isolationsschicht des supraleitenden Elements so gewählt ist, dass gilt:

$$D \geq k \cdot \left[ \frac{E_\parallel \cdot L}{m \cdot E_\perp^{krit}} - \sum_i \frac{\varepsilon_i \cdot d_i}{\varepsilon_{Iso}} \right]$$

mit i: Zählvariable von dielektrischen Schichten des supraleitenden Elements jeweils sowohl zwischen Substrat und Supraleiterschicht als auch zwischen Substrat und metallsicher Schutzschicht ohne die Isolationsschicht, $\varepsilon_i$ : Dielektrizitätskonstante der i-ten dielektrischen Schicht, $\varepsilon_{Iso}$ : Dielektrizitätskonstante der Isolationsschicht, $d_i$ Dicke der i-ten dielektrischen Schicht, $E_\perp^{krit}$: transversale Durchbruchfeldstärke in der Isolationsschicht; m: Geometrieparameter mit m=2 für mit und m=1 für ohne eine im Längsschnitt näherungsweise in der Mitte der Isolationsschicht eingerichtete elektrisch leitende Verbindung zwischen dem metallischen Substrat und der Supraleiterschicht, und k: Sicherheitsparameter mit k≥1. Mit dieser Wahl von L und D kann sichergestellt werden, dass das supraleitende Element mehrfache und auch andauernde Quenchs gut übersteht. $E_\parallel^{krit}$ kann für einen bestimmten Typ von Supraleiterschicht leicht experimentell bestimmt werden, ebenso kann $E_\perp^{krit}$ für ein Isolationsschicht-Material leicht experimentell bestimmt werden. Durch die Wahl des Sicherheitsparameters k > 1 kann eine Reserve für unvorhergesehene Belastungen (Spannungsspitzen) eingerichtet werden; bevorzugt beträgt k wenigstens 3.

Bei einer bevorzugten Variante der erfindungsgemäßen Verwendung gilt:

0,5 V/cm ≤ $E_\parallel^{krit}$ ≤ 10 V/cm, und/oder
$2 \cdot 10^3$ V/cm ≤ $E_\perp^{krit}$ ≤ $5 \cdot 10^5$ V/cm. Mit diesen Wertebereichen kann in der Praxis gut gearbeitet werden.

Vorteilhaft ist weiterhin eine Variante, die vorsieht, dass L ≥ 50 cm, bevorzugt L ≥ 150 cm, besonders bevorzugt L ≥ 200 cm. Diese Längen sind in der Praxis noch gut zu fertigen. Größere Längen reduzieren grundsätzlich die Feldstärke $E_\parallel$ parallel zur Längsrichtung des supraleitenden Substrats.

Besonders bevorzugt ist weiterhin eine Variante der erfindungsgemäßen Verwendung, die vorsieht, dass das supraleitende Element in eine Serienschaltung von weiteren supraleitenden Elementen eingefügt ist, deren Supraleiterschichten elektrisch miteinander verbunden sind und deren Substrate voneinander elektrisch isoliert sind, und dass die im Quenchfall des supraleitenden Elements an diesem anliegende äußere Spannung $V_{ext}^{elem}$ sich ergibt über

$V_{ext}^{elem} = V_{ext}^{ges} \cdot L / L_{ges}$, mit $V_{ext}^{ges}$: über die Serienschaltung von supraleitendem Element und den weiteren supraleitenden Elementen insgesamt durch die äußere Spannungsquelle anliegende Spannung, und $L_{ges}$: Summe der Länge des supraleitenden Elements und der Längen der weiteren supraleitenden Elemente. Durch die Serienschaltung der supraleitenden Elemente kann die insgesamt anliegende äußere Spannung $V_{ext}^{ges}$ auf die (typischerweise gleichartigen) supraleitenden Elemente aufgeteilt werden. Insbesondere kann über eine ausreichend hohe Anzahl bzw. ausreichend große Länge der weiteren supraleitenden Elemente die am supraleitenden Element anliegende äußere Spannung $V_{ext}^{elem}$ so weit aufgeteilt wird, dass $E_\parallel^{krit}$ (und auch $E_\perp^{krit}$) nicht überschritten werden.

Bei einer Weiterentwicklung dieser Variante gilt: $V_{ext}^{ges} \geq 10$ kV. Gerade bei hohen externen Spannungen kommen die Vorteile der hohen Durchschlagfestigkeit der Isolationsschicht im supraleitenden Element besonders zum Tragen.

Bevorzugt ist weiterhin eine Variante, bei der das supraleitende Element in einem supraleitenden Fehlerstrombegrenzer verbaut ist. Bei Fehlerstrombegrenzern werden besonders quenchresistente supraleitende Elemente benötigt, da der Quench hier zur gewünschten Sicherungsfunktion des Fehlerstrombegrenzers gehört. Der Fehlerstrombegrenzer kann vom resistiven oder kapazitiven Typ sein.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1      eine schematische Querschnittsdarstellung eines ersten supraleitenden Elements zur allgemeinen Erläuterung;

Fig. 2      eine schematische Querschnittsdarstellung eines zweiten supraleitenden Elements zur allgemeinen Erläuterung;

Fig. 3a     eine schematische Querschnittsdarstellung einer Ausführungsform eines erfindungsgemäßen supraleitenden Elements;

Fig. 3b     ein schematischer Längsschnitt des supraleitenden Elements von Fig. 3a;

Fig. 3c     eine schematische, perspektivische Ansicht des supraleitenden Elements von Fig. 3a,

Fig. 4      eine schematische Darstellung einer Serienschaltung mit einem supraleitenden Element und weiteren supraleitenden Elementen gemäß der Erfindung.

Man beachte, dass in den nachfolgend beschriebenen Figuren die Strukturen größtenteils übertrieben dargestellt werden, um die Merkmale der Erfindung zu verdeutlichen. Die Figuren sind daher nicht maßstäblich zu verstehen.

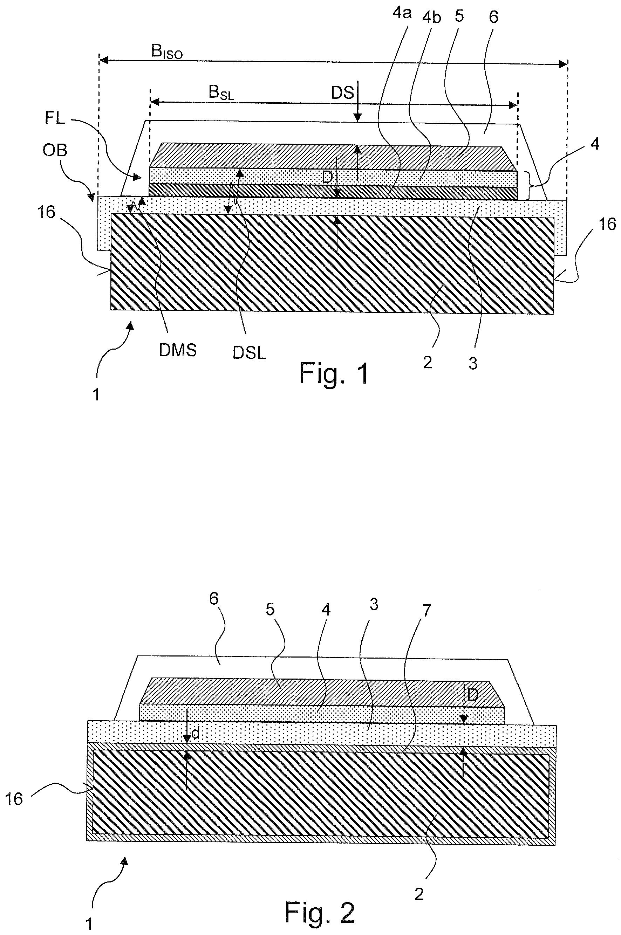

Die Fig. 1 zeigt ein erstes supraleitendes Element 1 im Querschnitt (senkrecht zur Stromtragerichtung/Längsrichtung) zur allgemeinen Erläuterung. Das supraleitende Element 1 ist im wesentlichen bandförmig aufgebaut.

Auf einem metallischen Substrat 2, beispielsweise aus Stahl, ist eine Isolationsschicht 3, beispielsweise aus Aluminiumphosphat, abgeschieden. Die Isolationsschicht 3 weist eine Dicke D auf, und die Isolationsschicht 3 ist hier nicht nur auf der Oberseite des Substrats 2, sondern auch in einem oberen Bereich OB an den kurzen Seiten 16 des Substrats 2 abgeschieden.

Auf der Isolationsschicht 3 ist hier eine Pufferschicht 4 mit zwei Subschichten 4a, 4b abgeschieden. Die untere Subschicht 4a ist im gezeigten Beispiel elektrisch leitfähig (beispielsweise eine CrNi-Legierung), und die obere Subschicht 4b ist elektrisch isolierend (beispielsweise $CeO_2$).

Auf der Pufferschicht 4 ist ein Supraleiterschicht 5 (bevorzugt aus Hochtemperatursupraleitermaterial mit einer Sprungtemperatur von 40 K oder höher, insbesondere YBCO) abgeschieden. Die laterale Ausdehnung (Breite) $B_{SL}$ der Supraleiterschicht 5 ist dabei geringer als die laterale Ausdehnung (Breite) $B_{ISO}$ der Isolationsschicht 3, und die Isolationsschicht 3 ragt beidenends (links und rechts) über die Supraleiterschicht 5 bzw. den von ihr überdeckten Bereich des Substrats 2 hinaus.

Auf der Supraleiterschicht 5 ist wiederum eine metallische Schutzschicht 6 (beispielsweise eine AuAg-Legierung) mit der Dicke DS abgeschieden. Die metallische Schutzschicht 6 überdeckt dabei haubenartig die Supraleiterschicht 5 und hier auch die Pufferschicht 4. Mit ihren seitlichen Flanken FL versiegelt die metallische Schutzschicht 6 auch die Seitenflächen der Supraleiterschicht 5, so dass diese im Querschnitt allseitig vor chemischen Angriffen geschützt ist. Die Flanken FL der metallischen Schutzschicht 6 berühren unterenends die Isolationsschicht 3, so dass die Isolationsschicht 3 einen elektrischen Kontakt zwischen der metallischen Schutzschicht 6 und dem metallischen Substrat 2 unterbindet. Die Flanken FL berühren dabei die Isolationsschicht 3 insbesondere in dem gegenüber der Supraleiterschicht 5 lateral überstehenden Bereich. Bevorzugt nutzen die Flanken FL dabei nur etwa die Hälfte oder weniger des lateral überstehenden Bereichs der Isolationsschicht 3 als Auflagefläche.

Die Dicke D der Isolationsschicht 3 reicht aus, um einen transversalen Spannungsdurchbruch DSL zwischen dem metallischen Substrat 2 und der Supraleiterschicht 5, und auch einen transversalen Spannungsdurchbruch DMS zwischen dem metallischen Substrat 2 und der metallischen Schutzschicht 6 bis zu einer Spannung von wenigstens 25 V, bevorzugt wenigstens 50V, zu verhindern. Mit anderen Worten, bei einer Spannungsdifferenz von 25V, bevorzugt 50 V, zwischen dem metallischen Substrat 2 einerseits und der metallischen Schutzschicht 6 und der Supraleiterschicht 5 (die in der Regel näherungsweise gleiches Potential aufweisen) andererseits kommt es noch nicht zu einem Spannungsdurchbruch. Man beachte, dass die notwendige Dicke D dabei insbesondere vom Material der Isolationsschicht 3 abhängt. Die Durchbruchspannung steigt mit zunehmender Dicke D an.

Im Allgemeinen können zur Abscheidung der Schichten 3, 4, 5, 6 jeweils an sich bekannte Verfahren eingesetzt werden, beispielsweise chemische Gasphasenabscheidung (CVD) und physikalische Vapor-Deposition (PVD), inklusive Gepulste Laser-Deposition, oder auch Abscheidung aus der flüssigen Phase (chemical solution deposition CSD, bzw. metal organic deposition MOD, typischerweise mit Tauchbeschichtung, Sprühbeschichtung oder Bedrucken und anschließendem Tempern, vor allem für die Isolationsschicht, meist in einem mehrstufigen Abscheideprozess).

**Fig. 2** zeigt ein weiteres supraleitendes Element 1 im Querschnitt zur allgemeinen Erläuterung.

Das metallische Substrat 2 ist hier allseitig von einer Planarisierungsschicht 7 umgeben, die beispielsweise mittels Tauchbeschichtung und Tempern aufgetragen wurde. Die Planarisierungsschicht 7 ist jedoch mit ihrer Dicke d relativ dünn, beispielsweise ca. 0,3 μm, und besitzt daher nur eine geringe Durchschlagfestigkeit.

Auf der Oberseite des supraleitenden Elements 1 ist daher eine Isolationsschicht 3 der Dicke D aufgebracht, mit der eine Durchbruchspannung von wenigstens 25V, bevorzugt wenigstens 50V, vom metallischen Substrat 2 zu einer Supraleiterschicht 5, die auf einer dielektrischen Pufferschicht 4 angeordnet ist, und zu einer metallischen Schutzschicht 6 bereitgestellt wird. Die metallische Schutzsicht 6 überspannt dabei wiederum haubenartig die Supraleiterschicht 5 und auch die Pufferschicht 4.

Die Isolationsschicht 3 ragt wiederum lateral über die Supraleiterschicht 5 deutlich hinaus, jedoch ist in diesem Beispiel keine Isolationsschicht 3 an den kurzen Seiten 16 des Substrats 2 vorgesehen.

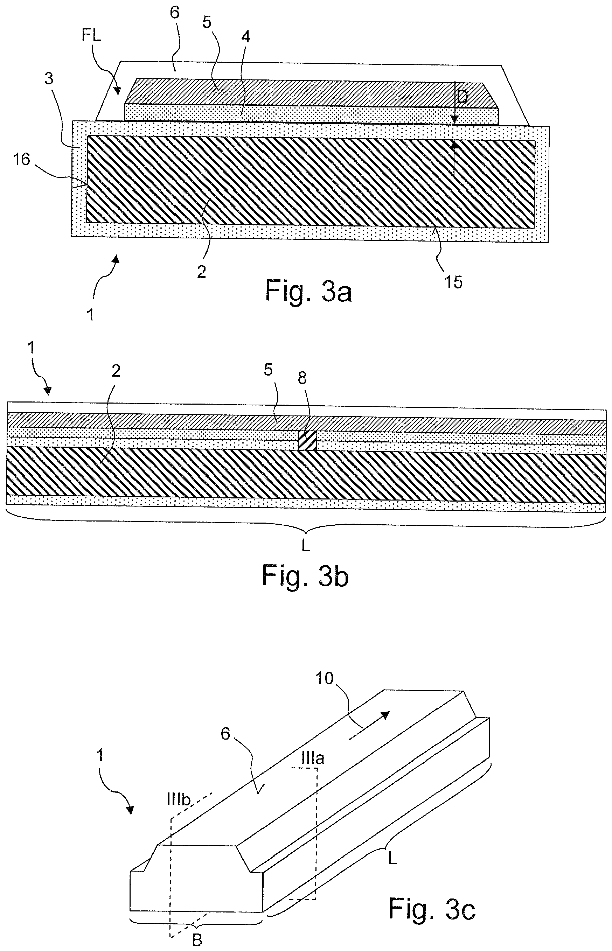

Die **Fig. 3a** zeigt im Querschnitt eine Ausführungsform eines erfindungsgemäßen supraleitenden Elements 1.

Das metallische Substrat 2 ist hierbei im Querschnitt allseitig von einer Isolationsschicht 3 umgeben, sodass auch die Unterseite 15 und die links und rechts gelegenen kurzen Seiten 16 des Substrats 2 von der Isolationsschicht 3 umhüllt werden. Auf der Isolationsschicht 3 ist eine dielektrische Pufferschicht 4, und auf dieser wiederum eine Supraleiterschicht 5 abgeschieden. Eine metallische Schutzschicht 6 umschließt haubenartig die Supraleiterschicht 5 und auch die Pufferschicht 4. Die Flanken FL der metallischen Schutzschicht 6 liegen jeweils auf Bereichen der Isolationsschicht 3 auf, die seitlich über die Supraleiterschicht 5 bzw. den von der Supraleiterschicht 5 überspannten Bereich des Substrats 2 hinausragen.

Die Isolationsschicht 3 kann hierbei leicht mittels Tauchbeschichtung und Tempern abgeschieden werden, wobei zum Erreichen einer erfindungsgemäßen Durchbruchspannung zwischen metallischem Substrat 2 einerseits und metallischer Schutzschicht 6 und Supraleiterschicht 5 andererseits von wenigstens 25V, bevorzugt wenigstens 50V, mehrere Abscheidungsiterationen zum Aufbau der erforderlichen Schichtdicke D durchgeführt werden können.

**Fig. 3b** zeigt einen Längsschnitt (entlang der Stromtragerichtung) durch das supraleitende Element 1 der Fig. 3a. Etwa bei der halben Längserstreckung des supraleitenden Elements 1 ist eine elektrisch leitende Verbindung 8 vorgesehen, beispielsweise aus einem Edelmetall oder einer Edelmetalllegierung, die das metallische Substrat 2 mit der Supraleiterschicht 5 verbindet. Dadurch wird im Quenchfall die über die Länge L des supraleitenden Elements 1 anliegende externe Spannung bezüglich der Spannungsdifferenz zwischen Substrat 2 und Supraleiterschicht 5 effektiv näherungsweise halbiert, und somit die Gefahr eines Spannungsdurchbruchs durch die Isolationsschicht 3 entsprechend vermindert.

**Fig. 3c** zeigt eine schematische Schrägansicht des supraleitenden Elements 1 von Fig. 3a und 3b; die Querschnittsebene von Fig. 3a ist mit IIIa markiert, und die Längsschnittebene von Fig. 3b ist mit IIIb markiert.

Das supraleitende Element 1 dient dazu, einen in Pfeilrichtung 10 (Längsrichtung) fließenden Strom supraleitend zu tragen. Das supraleitende Element hat die Länge L und die Breite B. Im Quenchfall steht als normalleitender Strompfad für die Supraleiterschicht lediglich die metallische Schutzschicht 6 zur Verfügung, diese ist jedoch relativ dünn ausgebildet, so dass sich ein longitudinaler Widerstand von bevorzugt zwischen 5 und 100 Ohm pro 1 cm Breite ergibt (der longitudinale Widerstand bestimmt sich aus der Querschnittsfläche der metallischen Schutzschicht 6 und dem spezifischen Widerstand des Schutzschichtmaterials). Bei einer Länge L von beispielsweise 1,50 m, einer Breite B von 4 cm und einem longitudinalen Widerstand von 20 Ohm pro 1 m Länge und je 1 cm Breite ergibt sich beispielsweise ein absoluter Widerstand der metallischen Schutzschicht 6 zwischen den Stirnseiten des supraleitenden Elements 1 von

$$R = (20 \text{ Ohm} * \text{cm/m}) * 1{,}50 \text{ m} / 4 \text{ cm} = 7{,}5 \text{ Ohm}.$$

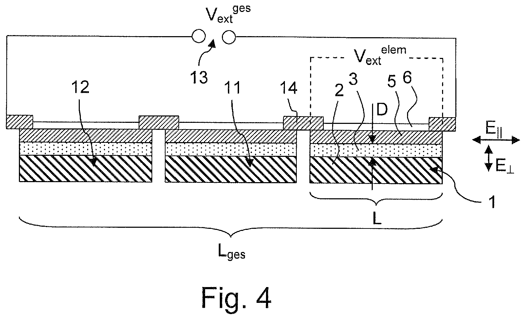

In der **Fig. 4** ist eine Serienschaltung eines erfindungsgemäßen, supraleitenden Elements 1 und weiteren, hier baugleichen supraleitenden Elementen 11, 12 dargestellt. Obwohl insgesamt nur drei supraleitende Elemente 1, 11, 12 gezeigt sind, kann die Serienschaltung auch noch mehr supraleitende Elemente, etwa 50 oder mehr, umfassen. Diese Serienschaltung kann beispielsweise als ein resistiver Fehlerstrombegrenzer für einen in Serie geschalteten, nicht näher dargestellten Verbraucher eingesetzt werden.

Die Serienschaltung ist durch eine äußere Spannungsquelle 13 einer Spannung $V_{ext}^{ges}$ ausgesetzt, die im Quenchfall verteilt über die supraleitenden Elemente 1, 11, 12 abfällt. Man beachte, dass dabei die metallischen Substrate 2 durch die Isolationsschichten 3 von den Supraleiterschichten 5 und den metallischen Schutzschichten 6 galvanisch getrennt sind. Über dem supraleitenden Element 1 fällt ein Anteil $V_{ext}^{elem}$ von $V_{ext}^{ges} * L/L_{ges}$ ab, wobei $L_{ges}$ die Summe der Längen L der einzelnen supraleitende Elemente 1, 11, 12 darstellt; in der Regel sind die Zwischenräume zwischen den supraleitenden Elementen 1, 11, 12 im Vergleich zu $L_{ges}$ vernachlässigbar klein, obwohl die Substrate 2 voneinander elektrisch isoliert sind. Man beachte, dass die Supraleiterschichten 5 über Brücken 14 supraleitend und im Quenchfall normalleitend miteinander verbunden sind.

Die am supraleitenden Element 1 anliegende Spannung $V_{ext}^{elem}$ fällt über die supraleitende Schicht 5 gleichmäßig ab; es ergibt sich ein elektrisches Feld $E_{\parallel}$ von $V_{ext}^{elem}/L$ in der supraleitenden Schicht 5. Durch eine ausreichende Unterteilung (insbesondere eine genügende Anzahl von supraleitenden Elementen) kann dabei die Feldstärke unterhalb einer kritischen Feldstärke $E_{\parallel}^{krit}$, oberhalb der es zu Beschädigungen der Supraleiterschicht 5 kommt, gehalten werden.

Da das Substrat 2 elektrisch leitet, herrscht dort überall das gleiche elektrische Potential. Da die beiden Enden der Supraleiterschicht 5 jedoch $V_{ext}^{elem}$ ausgesetzt sind, kann zwischen dem Substrat 2 und der Supraleiterschicht 5 eine Spannungsdifferenz lokal von bis zu $V_{ext}^{elem}$ herrschen, die nicht für einen Spannungsdurchbruch senkrecht durch die Isolationsschicht 3 sorgen darf, wenn eine Beteiligung des Substrats 2 an der Stromleitung im Quenchfall vermieden werden soll. Entsprechend ist die transversale Feldstärke $E_{\perp}$ in der Isolationsschicht 3 hier $V_{ext}^{elem}/D$, wobei D die Schichtdicke der Isolationsschicht 3 beschreibt. Man beachte, dass bei Nutzung einer mittigen elektrischen Verbindung (siehe Fig. 3b) sich die anliegende Spannung in Hinblick auf $E_{\perp}$ effektiv halbiert.

Die transversale Durchbruchfeldstärke $E_{\perp}^{krit}$ ist eine Materialeigenschaft des in der Isolationsschicht 3 verbauten Materials. Ist diese bekannt, und auch die anliegende externe Spannung $V_{ext}^{elem}$ bekannt, kann damit die erforderliche Dicke D, bevorzugt mit einem Sicherheitszuschlag, bestimmt werden. Falls zusätzlich zur Isolationsschicht 3 weitere dielektrische Schichten zwischen Substrat 2 und Supraleiterschicht 5, und zwischen Substrat 2 und metallischer Schutzschicht 6 vorhanden sind (etwa eine Planarisierungsschicht oder eine dielektrische Pufferschicht), können diese die erforderliche Schichtdicke D der Isolationsschicht 3 vermindern. Nur eine solche dielektrische Schicht, die sowohl das Substrat 2 und die Supraleiterschicht 5, als auch das Substrat 2 und die metallische Schutzschicht 6 über die ganzen jeweiligen Breiten separiert, kann dabei zur Verringerung der erforderlichen Schichtdicke D beitragen (In der Bauform von Fig. 1 kann die dielektrische Pufferschicht 4a nicht beitragen, da sie seitlich nicht bis unter die gesamte metallische Schutzschicht 6 ausgreift. In Fig. 2 kann nur die Planarisierungsschicht 7 beitragen. In Fig. 3a kann wiederum die dielektrische Pufferschicht 4 nicht beitragen, weil sie nicht weit genug seitlich ausgreift). Hierbei kann der Beitrag der weiteren dielektrischen Schichten über deren Dicke d und das Verhältnis der Dielektrizitätskonstanten von Isolationsschicht 3 und einer jeweiligen weiteren dielektrischen Schicht i angenähert werden, wie in Anspruch 15 angegeben.

Erfindungsgemäß weisen die supraleitenden Elemente 1, 11, 12 Durchbruchspannungen von 25V oder höher, bevorzugt 50V oder höher auf. Dadurch können auch externe Spannungen im kV-Bereich, die für supraleitende Fehlerstrombegrenzer benötigt werden können, mit einer überschaubaren Zahl von Supraleiterelementen 1, 11, 12 in Serie geschaltet gehandhabt werden.

Ein typisches supraleitendes Element gemäß der Erfindung weist als Substrat ein Band von rostfreiem Stahl mit einer Dicke zwischen 50 $\mu$m und 200 $\mu$m, bevorzugt ca. 100 $\mu$m, und einer Breite von 20 bis 80mm, bevorzugt ca. 40 mm, auf, weiterhin eine Isolationsschicht, beispielsweise aus Yttrium-stabilisiertem Zirkon, mit einer Dicke zwischen 1,5 $\mu$m und 10 $\mu$m (wobei die Dicke, je nach Materialqualität, ausreicht, um eine Durchbruchspannung von wenigstens 25 V zu gewährleisten), weiterhin optional eine Pufferschicht, beispielsweise aus CeO2, mit einer Dicke zwischen 0,05 $\mu$m

und 0,2μm, bevorzugt 0,1 μm, weiterhin eine Supraleiterschicht, bevorzugt Hochtemperatursupraleiterschicht, etwa aus YBCO, mit einer Dicke zwischen 0,8μm und 4μm, bevorzugt zwischen 1μm und 2μm, und weiterhin eine metallischen Schutzschicht, beispielsweise aus einer Ag-Au-Legierung (50Gew%/50Gew%). Ein supraleitendes Element kann dabei eine Länge von 0,5 m oder mehr aufweisen. Bei einem solchen Aufbau wurden mehrfache Quenchs mit einer Dauer von jeweils 300 Sekunden Dauer beschädigungsfrei überstanden.

Man beachte, dass hier quantitativ angegebene, von Materialeigenschaften abhängige Größen, insbesondere ein longitudinaler Widerstand der metallischen Schutzschicht und die transversale Durchbruchspannung, bei Raumtemperatur (20°C) bestimmt werden können.

Zusammenfassend beschreibt die Erfindung einen supraleitenden Bandleiter, insbesondere HTSL-Bandleiter, wobei dessen Supraleiterschicht (Supraleiterfilm) mit einer metallischen Schutzschicht abgedeckt ist, und wobei eine Isolationsschicht dessen metallisches Substrat (Substratband) von der Supraleiterschicht und der metallischen Schutzschicht elektrisch trennt. Dabei ragt die Isolationsschicht im Querschnitt senkrecht zur Längsrichtung (Stromtragerichtung) des Bandleiters beidseitig über den von der Supraleiterschicht und bevorzugt auch den von der metallischen Isolationsschicht überdeckten Oberflächenbereich des metallischen Substrats hinaus (typischerweise mit einem Überstand von jeweils wenigstens 1 mm, bevorzugt wenigstens 2 mm) und die Isolationsschicht deckt auch die kurzen Seiten des Substrats ganz ab, oder umhüllt sogar das metallische Substrat vollständig. Die Isolationsschicht ist so dick, dass sie einen transversalen Spannungsdurchbruch bzw. einen Spannungsdurchbruch senkrecht durch die Isolationsschicht bis wenigstens 25V, bevorzugt bis wenigstens 50V, verhindert. Die im Quenchfall anliegende Spannung zwischen dem metallischem Substrat einerseits und andererseits der Supraleiterschicht (bzw. der metallischen Schutzschicht, die im Wesentlichen auf dem gleichen elektrischen Potential ist wie die Supraleiterschicht) erzeugt dabei ein elektrisches Feld, das im Wesentlichen senkrecht durch die Isolationsschicht (und insbesondere im Wesentlichen senkrecht durch die Grenzflächen der Isolationsschicht mit dem metallischen Substrat und mit der Supraleiterschicht oder der metallischen Schutzschicht) verläuft. Im Quenchfall trägt dann das kostengünstige und gut handzuhabende metallische Substrat nicht zum normalleitenden Stromfluss bei, wodurch eine Erwärmung des Bandleiters verringert wird, und so eine Rückkehr in den supraleitenden Zustand erleichtert und beschleunigt wird.

**Patentansprüche**

1. Supraleitendes Element (1), umfassend ein metallisches Substrat (2), eine Isolationsschicht (3), eine Supraleiterschicht (5) und eine metallische Schutzschicht (6), wobei die Isolationsschicht (3) zwischen dem Substrat (2) und der Supraleiterschicht (5) angeordnet ist,
wobei die Isolationsschicht (3) in einem Querschnitt des supraleitenden Elements (1) sich beidenends über den von der Supraleiterschicht (5) überdeckten Bereich ($B_{SL}$) des Substrats (2) hinaus erstreckt,
und wobei die Isolationsschicht (3) die Supraleiterschicht (5) und die metallische Schutzschicht (6) vom Substrat (2) galvanisch trennt,
**dadurch gekennzeichnet,**
**dass** eine Dicke D der Isolationsschicht (3) so gewählt ist, dass das supraleitende Element (1) eine transversale Durchbruchspannung vom metallischen Substrat (2) zur Supraleiterschicht (5) und zur metallischen Schutzschicht (6) von wenigstens 25 V aufweist,
und **dass** die Isolationsschicht (3) im Querschnitt auch die kurzen Seiten (16) des Substrats (2) ganz abdeckt.

2. Supraleitendes Element (1) nach Anspruch 1, **dadurch gekennzeichnet, dass** die metallische Schutzschicht (6) die Isolationsschicht (3) berührt.

3. Supraleitendes Element (1) nach Anspruch 1 oder 2, **dadurch gekennzeichnet, dass** die metallische Schutzschicht (6) im Querschnitt die Supraleiterschicht (5) haubenartig umschließt.

4. Supraleitendes Element (1) nach einem der vorhergehenden Ansprüche, **dadurch gekennzeichnet, dass** die Isolationsschicht (3) auch eine der Supraleiterschicht (5) abgewandte Unterseite (15) des Substrats (2) abdeckt.

5. Supraleitendes Element (1) nach einem der vorhergehenden Ansprüche, **dadurch gekennzeichnet, dass** zusätzlich zur Isolationsschicht (3) eine Planarisierungsschicht (7) vorgesehen ist, die auf dem Substrat (2) abgeschieden ist.

6. Supraleitendes Element (1) nach einem der vorhergehenden Ansprüche, **dadurch gekennzeichnet, dass** die Dicke D der Isolationsschicht (3) so gewählt ist, dass das supraleitende Element (1) eine transversale Durchbruchspannung vom metallischen Substrat (2) zur Supraleiterschicht (5) und zur metallischen Schutzschicht (6) von wenigstens 50 V, bevorzugt wenigstens 100 V, besonders bevorzugt wenigstens 300 V, aufweist.

7. Supraleitendes Element (1) nach einem der vorhergehenden Ansprüche, **dadurch gekennzeichnet, dass** die Isolationsschicht (3) ein oder mehrere Metalloxide enthält, insbesondere yttriumstabilisiertes Zirkonoxid, Zirkonoxid, Yttriumoxid, Strontiumtitanat, Aluminiumoxid, Ceroxid, Gadoliniumzirkonat, Bariumzirkonat und/oder Magnesiumoxid.

8. Supraleitendes Element (1) nach einem der vorhergehenden Ansprüche, **dadurch gekennzeichnet, dass** das supraleitende Element (1) eine Pufferschicht (4) enthält, wobei die Pufferschicht (4) zwischen der Isolationsschicht (3) und der Supraleiterschicht (5) angeordnet ist, insbesondere wobei die Pufferschicht (4) wenigstens eine dielektrische Sub-Schicht (4a) enthält.

9. Supraleitendes Element (1) nach einem der vorhergehenden Ansprüche, **dadurch gekennzeichnet, dass** im Längsschnitt des supraleitenden Elements (1) näherungsweise in der Mitte der Isolationsschicht (3) eine elektrisch leitende Verbindung (8) zwischen dem metallischen Substrat (2) und der Supraleiterschicht (5) eingerichtet ist.

10. Supraleitendes Element (1) nach einem der vorhergehenden Ansprüche,
**dadurch gekennzeichnet, dass** die metallische Schutzschicht (6) einen longitudinalen Widerstand in Längsrichtung des supraleitenden Elements (1) zwischen 5 und 100 Ohm pro m Länge (L) und je cm Breite (B) des supraleitenden Elements (1) aufweist, bevorzugt zwischen 15 und 40 Ohm pro m Länge (L) und je cm Breite (B) des supraleitenden Elements (1).

11. Verwendung eines supraleitenden Elements (1) nach einem der vorhergehenden Ansprüche an einer äußeren Spannungsquelle (13), durch die im Quenchfall des supraleitenden Elements (1) eine äußere Spannung $V_{ext}^{elem}$ am supraleitenden Element (1) anliegt,
wobei die Länge L des supraleitenden Elements (1) so gewählt ist, dass das sich im Quenchfall einstellende elektrische Feld $E_\parallel$ entlang des supraleitenden Elements (1), das sich mit $E_\parallel = V_{ext}^{elem}/L$ ergibt, kleiner ist als ein kritisches elektrisches Feld $E_\parallel^{krit}$, das die Supraleiterschicht (5) noch ohne Beschädigungen aushalten kann,
und wobei die Dicke D der Isolationsschicht (3) des supraleitenden Elements (1) so gewählt ist, dass gilt:

$$D \geq k \cdot \left[ \frac{E_\parallel \cdot L}{m \cdot E_\perp^{krit}} - \sum_i \frac{\varepsilon_i \cdot d_i}{\varepsilon_{Iso}} \right]$$

mit i: Zählvariable von dielektrischen Schichten des supraleitenden Elements (1) jeweils sowohl zwischen Substrat (2) und Supraleiterschicht (5) als auch zwischen Substrat (2) und metallsicher Schutzschicht (6) ohne die Isolationsschicht (3), $\varepsilon_i$: Dielektrizitätskonstante der i-ten dielektrischen Schicht, $\varepsilon_{Iso}$: Dielektrizitätskonstante der Isolationsschicht (3), $d_i$ Dicke der i-ten dielektrischen Schicht, $E_\perp^{krit}$: transversale Durchbruchfeldstärke in der Isolationsschicht (3); m: Geometrieparameter mit m=2 für mit und m=1 für ohne eine im Längsschnitt näherungsweise in der Mitte der Isolationsschicht (3) eingerichtete elektrisch leitende Verbindung (8) zwischen dem metallischen Substrat (2) und der Supraleiterschicht (5), und k: Sicherheitsparameter mit k≥1.

12. Verwendung nach Anspruch 11, **dadurch gekennzeichnet, dass** gilt:

$$0{,}5 \text{ V/cm} \leq E_\parallel^{krit} \leq 10 \text{ V/cm,}$$

und/oder

$$2 \cdot 10^3 \text{ V/cm} \leq E_\perp^{krit} \leq 5 \cdot 10^5 \text{ V/cm.}$$

13. Verwendung nach Anspruch 11 oder 12, **dadurch gekennzeichnet, dass** L ≥ 50 cm, bevorzugt L ≥ 150 cm, besonders bevorzugt L ≥ 200 cm.

14. Verwendung nach einem der Ansprüche 11 bis 13, **dadurch gekennzeichnet,**

**dass** das supraleitende Element (1) in eine Serienschaltung von weiteren supraleitenden Elementen (11, 12) eingefügt ist, deren Supraleiterschichten (5) elektrisch miteinander verbunden sind und deren Substrate (2) voneinander elektrisch isoliert sind,
und **dass** die im Quenchfall des supraleitenden Elements (1) an diesem anliegende äußere Spannung $V_{ext}^{elem}$ sich ergibt über

$$V_{ext}^{elem} = V_{ext}^{ges} \cdot L \, / \, L_{ges},$$

mit $V_{ext}^{ges}$ : über die Serienschaltung von supraleitendem Element (1) und den weiteren supraleitenden Elementen (11, 12) insgesamt durch die äußere Spannungsquelle (13) anliegende Spannung, und $L_{ges}$ : Summe der Länge des supraleitenden Elements (1) und der Längen der weiteren supraleitenden Elemente (11, 12).

15. Verwendung nach Anspruch 14, **dadurch gekennzeichnet, dass** gilt:

$$V_{ext}^{ges} \geq 10 \text{ kV}.$$

**Claims**

1. A superconducting element (1) comprising a metallic substrate (2), an insulating layer (3), a superconductor layer (5) and a metallic protective layer (6), wherein the insulating layer (3) is disposed between the substrate (2) and the superconductor layer (5), wherein, in cross-section of the superconducting element (1), the insulating layer (3) extends at both ends thereof past an area ($B_{SL}$) of the substrate (2) covered by the superconductor layer (5), and wherein the insulating layer (3) galvanically separates the superconductor layer (5) and the metallic protective layer (6) from the substrate (2),
**characterized in that**
the insulating layer (3) has a thickness D which is selected in such a fashion that the superconducting element (1) has a transverse breakdown voltage between the metallic substrate (2) and both the superconductor layer (5) as well as the metallic protective layer (6) of at least 25 V,
and that, in cross-section, the insulating layer (3) also completely covers the short sides (16) of the substrate (2).

2. The superconducting element (1) according to claim 1, **characterized in that** the metallic protective layer (6) contacts the insulating layer (3).

3. The superconducting element (1) according to claim 1 or 2, **characterized in that**, in cross-section, the metallic protective layer (6) surrounds the superconductor layer (5) like a hood.

4. The superconducting element (1) according to any one of the preceding claims, **characterized in that** the insulating layer (3) also covers a lower side (15) of the substrate (2) facing away from the superconductor layer (5).

5. The superconducting element (1) according to any one of the preceding claims, **characterized in that**, in addition to the insulating layer (3), a planarization layer (7) is provided, which is deposited on the substrate (2).

6. The superconducting element (1) according to any one of the preceding claims,
**characterized in that** the thickness D of the insulating layer (3) is selected in such a fashion that the superconducting element (1) has a transverse breakdown voltage between the metallic substrate (2) and both the superconductor layer (5) as well as the metallic protective layer (6) of at least 50 V, preferably at least 100 V, preferentially at least 300 V.

7. The superconducting element (1) according to any one of the preceding claims, **characterized in that** the insulating layer (3) contains one or more metal oxides, in particular yttrium-stabilized zircon oxide, zircon oxide, yttrium oxide, strontium titanate, aluminium oxide, ceroxide, gadolinium zirconate, barium zirconate and/or magnesium oxide.

8. The superconducting element (1) according to any one of the preceding claims,
**characterized in that** the superconducting element (1) comprises a buffer layer (4), wherein the buffer layer (4) is disposed between the insulating layer (3) and the superconductor layer (5), in particular wherein the buffer layer (4) has at least one dielectric sub-layer (4a).

9. The superconducting element (1) according to any one of the preceding claims, **characterized in that** an electrically conducting connection (8) is provided between the metallic substrate (2) and the superconductor layer (5), said electrically conducting connection (8) being disposed, in longitudinal section of the superconducting element (1), approximately in a center of the insulating layer (3).

10. The superconducting element (1) according to any one of the preceding claims, **characterized in that** the metallic protective layer (6) has a longitudinal resistance in a longitudinal direction of the superconducting element (1) of between 5 and 100 ohm per meter of length (L) and for each cm of width (B) of the superconducting element (1), preferably between 15 and 40 ohm per meter of length (L) and for each cm of width (B) of the superconducting element (1).

11. The use of a superconducting element (1) according to any one of the preceding claims on an external voltage source (13) which applies an external voltage $V_{ext}^{elem}$ to the superconducting element (1) in case of a quench of the superconducting element (1),
wherein the length L of the superconducting element (1) is selected such that an electric field En along the superconducting element (1),
which is generated in case of a quench, with En= $V_{ext}^{elem}$/L, is smaller than a critical electric field $E_{\parallel}^{krit}$ that the superconductor layer (5) can still withstand without being damaged;
and wherein the thickness D of the insulating layer (3) of the superconducting element (1) is selected such that the following applies:

$$D \geq k \cdot \left[ \frac{E_{\parallel} \cdot L}{m \cdot E_{\perp}^{krit}} - \sum_i \frac{\varepsilon_i \cdot d_i}{\varepsilon_{Iso}} \right]$$

with i: count variable of dielectric layers of the superconducting element (1) between both the substrate (2) and the superconductor layer (5) as well as between the substrate (2) and the metallic protective layer (6) without the insulating layer (5), $\varepsilon_i$, : dielectric constant of the i-th dielectric layer, $\varepsilon_{Iso}$ : dielectric constant of the insulating layer (3), $d_i$: thickness of the i-th dielectric layer, $E_{\perp}^{krit}$: transverse breakdown field strength in the insulating layer (3), m: a geometrical parameter, wherein m=2 when the superconducting element has an electrically conducting connection (8) between the metallic substrate (2) and the superconductor layer (5) located, in longitudinal section, approximately in a center of the insulating layer and m=1 without such an electrically conducting connection, and k: safety parameter, wherein k $\geq$ 1.

12. The use according to claim 11, **characterized in that** 0.5 V/cm $\leq E_{\parallel}^{krit} \leq$ 10 V/cm and/or $2 \cdot 10^3$ V/cm $\leq E_{\perp}^{krit} < 5 \cdot 10^5$ V/cm.

13. The use according to claim 11 or 12, **characterized in that** L $\geq$ 50 cm, preferably L $\geq$ 150 cm, preferentially L $\geq$ 200 cm.

14. The use according to any one of the claims 11 to 13, **characterized in that** the superconducting element (1) is included in a series connection of further superconducting elements (11, 12), the superconductor layers (5) of which are electrically connected to each other and substrates (2) of which are electrically insulated from each other, and that the external voltage $V_{ext}^{elem}$ that is applied to the superconducting element (1) in case of a quench thereof is $V_{ext}^{elem} = V_{ext}^{ges} \cdot$ L / $L_{ges}$, with $V_{ext}^{ges}$: an overall voltage applied by the external voltage source (13) across the series connection of the superconducting element (1) and the further superconducting elements (11, 12), and $L_{ges}$: sum of the length of the superconducting element (1) and lengths of the further superconducting elements (11, 12).

15. The use according to claim 14, **characterized in that** $V_{ext}^{ges} \geq$ 10 kV.

**Revendications**

1. Elément supraconducteur (1), comprenant un substrat métallique (2), une couche d'isolation (3), une couche supraconductrice (5) et une couche de protection métallique (6), la couche d'isolation (3) étant disposée entre le substrat (2) et la couche supraconductrice (5),

la couche d'isolation (3), dans une coupe transversale de l'élément supraconducteur (1), s'étendant aux deux extrémités au-delà de la zone ($B_{SL}$) du substrat (2) recouverte par la couche supraconductrice (5),

et la couche d'isolation (3) isolant galvaniquement la couche supraconductrice (5) et la couche de protection métallique (6) du substrat (2),

**caractérisé en ce**

**qu'**une épaisseur D de la couche d'isolation (3) est choisie de façon que l'élément supraconducteur (1) présente une tension de claquage transversal du substrat métallique (2) vers la couche supraconductrice (5) et vers la couche de protection métallique (6) d'au moins 25 V,

et **que** la couche d'isolation (3), en coupe transversale, recouvre aussi entièrement les petits côtés (16) du substrat (2).

2. Elément supraconducteur (1) selon la revendication 1, **caractérisé en ce que** la couche de protection métallique (6) touche la couche d'isolation (3).

3. Elément supraconducteur (1) selon la revendication 1 ou la revendication 2, **caractérisé en ce que** la couche de protection métallique (6), en coupe transversale, entoure la couche supraconductrice (5) à la manière d'une calotte.

4. Elément supraconducteur (1) selon l'une des revendications précédentes,

**caractérisé en ce que** la couche d'isolation (3) recouvre aussi une face inférieure (15) du substrat (2) opposée à la couche supraconductrice (5).

5. Elément supraconducteur (1) selon l'une des revendications précédentes,

**caractérisé en ce qu'**en plus de la couche d'isolation (3), une couche de planarisation (7), qui est déposée sur le substrat (2), est prévue.

6. Elément supraconducteur (1) selon l'une des revendications précédentes,

**caractérisé en ce que** l'épaisseur D de la couche d'isolation (3) est choisie de façon que l'élément supraconducteur (1) présente une tension de claquage transversal du substrat métallique (2) vers la couche supraconductrice (5) et vers la couche de protection métallique (6) d'au moins 50 V, de préférence d'au moins 100 V, particulièrement de préférence d'au moins 300 V.

7. Elément supraconducteur (1) selon l'une des revendications précédentes,

**caractérisé en ce que** la couche d'isolation (3) présente un ou plusieurs oxydes métalliques,

en particulier de l'oxyde de zirconium stabilisé à l'yttrium, de l'oxyde de zirconium, de l'oxyde d'yttrium, de l'oxyde de strontium, de l'oxyde d'aluminium, de l'oxyde de cérium, du zirconate de gadolinium, du zirconate de baryum et/ou de l'oxyde de magnésium.

8. Elément supraconducteur (1) selon l'une des revendications précédentes,

**caractérisé en ce que** l'élément supraconducteur (1) contient une couche tampon (4), laquelle couche tampon (4) est disposée entre la couche d'isolation (3) et la couche supraconductrice (5), en particulier laquelle couche tampon (4) contient au moins une sous-couche diélectrique (4a).

9. Elément supraconducteur (1) selon l'une des revendications précédentes,

**caractérisé en ce qu'**en coupe longitudinale de l'élément supraconducteur (1), approximativement au milieu de la couche d'isolation (3), une liaison électriquement conductrice (8) est ménagée entre le substrat métallique (2) et la couche supraconductrice (5).

10. Elément supraconducteur (1) selon l'une des revendications précédentes,

**caractérisé en ce que** la couche de protection métallique (6) présente, dans la direction longitudinale de l'élément supraconducteur (1), une résistance longitudinale comprise entre 5 et 100 ohms par m de longueur (L) et par cm de largeur (B) de l'élément supraconducteur (1), de préférence entre 15 et 40 ohms par m de longueur (L) et par cm de largeur (B) de l'élément supraconducteur (1).

11. Utilisation d'un élément supraconducteur (1) selon l'une des revendications précédentes sur une source de tension extérieure (13) qui, en cas de transition résistive (« quench ») de l'élément supraconducteur (1), applique une tension extérieure $V_{ext}^{elem}$ à l'élément supraconducteur (1),

la longueur L de l'élément supraconducteur (1) étant choisie de façon que le champ électrique $E_\parallel$ s'établissant le long de l'élément supraconducteur (1) en cas de quench, qui est donné par $E_\parallel = V_{ext}^{elem}/L$, soit plus petit qu'un champ électrique critique E∥$^{krit}$ que la couche supraconductrice (5) peut encore supporter sans dommages, et l'épaisseur D de la couche d'isolation (3) de l'élément supraconducteur (1) étant choisie de façon que :

$$D \geq k \cdot \left[ \frac{E_{\parallel} \cdot L}{m \cdot E_{\perp}^{krit}} - \sum_i \frac{\varepsilon_i \cdot d_i}{\varepsilon_{Iso}} \right]$$

avec i : variable de comptage de couches diélectriques de l'élément supraconducteur (1) chaque fois aussi bien entre substrat (2) et couche supraconductrice (5) qu'entre substrat (2) et couche de protection métallique (6) sans la couche d'isolation (3), $\varepsilon_i$ : constante diélectrique de la i$^{ème}$ couche diélectrique, $\varepsilon_{Iso}$ : constante diélectrique de la couche d'isolation (3), $d_i$ épaisseur de la i$^{ème}$ couche diélectrique, E⊥$^{krit}$ : intensité du champ de claquage transversal dans la couche d'isolation (3) ; m : paramètre géométrique avec m = 2 pour avec et m = 1 pour sans une liaison électriquement conductrice (8) ménagée en coupe longitudinale entre le substrat métallique (2) et la couche supraconductrice (5) approximativement au milieu de la couche d'isolation (3), et k : paramètre de sécurité avec k ≥ 1.

**12.** Utilisation selon la revendication 11, **caractérisée en ce que** :

$$0,5 \text{ V/cm} \leq \text{E} \parallel^{krit} \leq 10 \text{ V/cm,}$$

et/ou

$$2 \cdot 10^3 \text{ V/cm} \leq \text{E} \perp^{krit} \leq 5 \cdot 10^5 \text{ V/cm.}$$

**13.** Utilisation selon la revendication 11 ou la revendication 12, **caractérisée en ce que** L ≥ 50 cm, de préférence L ≥ 150 cm, particulièrement de préférence L ≥ 200 cm.

**14.** Utilisation selon l'une des revendications 11 à 13, **caractérisée en ce que** l'élément supraconducteur (1) est inséré dans un couplage en série d'autres éléments supraconducteurs (11, 12) dont les couches supraconductrices (5) sont reliées électriquement entre elles et dont les substrats (2) sont isolés électriquement les uns des autres, et qu'en cas de quench de l'élément supraconducteur (1), la tension extérieure $V_{ext}^{elem}$ appliquée à celui-ci est donnée par $V_{ext}^{elem} = V_{ext}^{ges} \cdot L / L_{ges}$, avec $V_{ext}^{ges}$ : tension totale appliquée par la source de tension extérieure (13) au couplage en série de l'élément supraconducteur (1) et des autres éléments supraconducteurs (11, 12), et $L_{ges}$: somme de la longueur de l'élément supraconducteur (1) et des longueurs des autres éléments supraconducteurs (11, 12).

**15.** Utilisation selon la revendication 14, **caractérisé en ce que** : $V_{ext}^{ges}$ ≥ 10 kV.

Fig. 1

Fig. 2

Fig. 3a

Fig. 3b

Fig. 3c

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090131262 A1
- US 7774035 B2
- EP 2117056 B1
- EP 2672537 A1
- EP 2192629 A1
- US 20120040100 A1
- DE 102004048439 B4
- US 20110319271 A1
- JP 2012028263 A
- US 20090302282 A1
- US 20050019615 A1
- US 20100197506 A1